# EUROPEAN PATENT SPECIFICATION

(11) **EP 4 407 677 B1**
(45) Date of publication and mention of the grant of the patent: **11.11.2026**
(21) Application number: 23866623.4
(22) Date of filing: 26.09.2023
(51) Int. Cl.: H10W 70/05, H10W 70/60, H10W 70/68, H10W 90/00

(54) **PACKAGING STRUCTURE, CHIP, ELECTRONIC DEVICE, MANUFACTURING METHOD FOR PACKAGING STRUCTURE, AND CHIP PACKAGING METHOD**
GEHÄUSESTRUKTUR, CHIP, ELEKTRONISCHE VORRICHTUNG, HERSTELLUNGSVERFAHREN FÜR GEHÄUSESTRUKTUR UND CHIPVERKAPSELUNGSVERFAHREN
STRUCTURE D'ENCAPSULATION, PUCE, DISPOSITIF ÉLECTRONIQUE, PROCÉDÉ DE FABRICATION DE STRUCTURE D'ENCAPSULATION ET PROCÉDÉ D'ENCAPSULATION DE PUCE

(30) Priority: 13.12.2022 CN 202211598610
(43) Date of publication of application: 31.07.2024
(73) Proprietor: Hygon Information Technology Co., Ltd., Binhai New Area, Tianjin 300392 (CN)
(72) Inventor: DU, Shuan, Binhai New Area, Tianjin 300392 (CN); LIU, Xinchun, Binhai New Area, Tianjin 300392 (CN)
(74) Representative: Maiwald GmbH
(86) International application number: PCT/CN2023/121594
(87) International publication number: WO 2024/125036

(56) References cited:
- CN-A- 114 400 219
- CN-A- 114 551 415
- CN-A- 116 053 245
- CN-A- 116 053 251
- US-A1- 2008 138 932
- US-A1- 2018 294 216
- US-A1- 2020 168 538
- US-A1- 2020 219 815
- US-A1- 2021 183 753
- US-A1- 2021 193 583
- US-A1- 2021 384 094

## Description

### CROSS-REFERENCE TO RELATED APPLICATION(S)

The present application claims the priority of China Patent Application No.202211598610.7 filed on December 13, 2022.

### TECHNICAL FIELD

Embodiments of the present disclosure relate to a package structure, a chip, an electronic apparatus, a manufacturing method for a package structure and a chip packaging method.

### BACKGROUND

With the increasing number of cores in high-end and high-performance chips such as central processing units (CPUs) and graphics processing units (GPUs), the chips are getting enlarged in their sizes, which results in gradually decreased yields. In order to improve the yield of chips, the industry's focus has generally turned to high-end and high-performance chips with smaller size (chiplets) to reduce the area of a single chip. In the case of chiplet, high-bandwidth interconnection is required between dies for communication. For this end, advanced packaging is necessary for high-density interconnection to satisfy such demands.

Usually, silicon interposer is used for high-density interconnection. Since a dielectric layer of the silicon interposer is made of silicon dioxide, the whole processing equipment and processing environment adopt traditional silicon process, and the overall cost is relatively high; at the same time, through silicon vias (TSVs) have to be formed in a back surface of the silicon interposer, so that necessary signals and power supplies can be led out to an Ajinomoto Build-up Film (ABF) substrate and then to the outside, which causes expensive cost in subsequent processing.

US2020219815A1 discloses microelectronic assemblies, and related devices and methods. For example, in some embodiments, a microelectronic assembly may include a package substrate, a first die coupled to the package substrate with first interconnects, and a second die coupled to the first die with second interconnects, wherein the second die is coupled to the package substrate with third interconnects, a communication network is at least partially included in the first die and at least partially included in the second die, and the communication network includes a communication pathway between the first die and the second die.

US2021384094A1 discloses hybrid microelectronic substrates, and related devices and methods. In some embodiments, a hybrid microelectronic substrate may include a low-density microelectronic substrate having a recess at a first surface, and a high-density microelectronic substrate disposed in the recess and coupled to a bottom of the recess via solder.

US2008138932A1 discloses semiconductor devices and method of manufacturing semiconductor devices. In some embodiments, a package substrate has a first and a second package substrate wherein each package substrate comprises an interconnection layer with metal routing layer and dielectric layer alternately stacked. The second package substrate is arranged in the cavity of the first package substrate. Document D3 does not disclose a second metal routing wherein both ends of the second metal routing are not connected with the plurality of second connection bumps.

US2021193583A1 discloses semiconductor package with high density interconnects. In some embodiments, a multilayer substrate (alternating conductive and dielectric layers) hosts two active electronic components: a first silicon die mounted on the substrate's external surface and a second silicon die partially embedded within a recess of the substrate.

### SUMMARY

In view of the above, embodiments of the present disclosure provide a package structure, a chip, an electronic apparatus and a chip packaging method, which may solve at least one of the technical problems in the prior art. The object is achieved by the features of the respective independent claims. Further embodiments are defined in the respective dependent claims.

In order to more clearly illustrate the technical solutions of the embodiments of the present disclosure, the drawings necessary for the description of the embodiments and examples will be briefly described in the following; it is obvious that the described drawings are only related to some embodiments and examples of the present disclosure, and other drawings can be obtained according to these drawings without creative work for those ordinary skilled in the art.
FIG. 1 is a schematic structural diagram of an example not forming part of the present invention but useful for understanding of a package structure of the present disclosure;
FIG. 2 is a schematic structural diagram of an embodiment of a chip (including the package structure shown in FIG. 1) of the present disclosure;
FIG. 3 is a schematic structural diagram of a first package substrate in FIG. 1;
FIG. 4 is a schematic structural diagram of a second package substrate in FIG. 1;
FIG. 5 is a flow chart of an embodiment of a manufacturing method for a package structure of the present disclosure;
FIGS. 6 to 10 are schematic diagrams of a process flow of forming a first package substrate in FIG. 5;
FIGS. 11 to 14 are schematic diagrams of a process flow of forming a second package substrate in FIG. 5; and
FIG. 15 is a flowchart of an embodiment of a chip packaging method of the present disclosure.

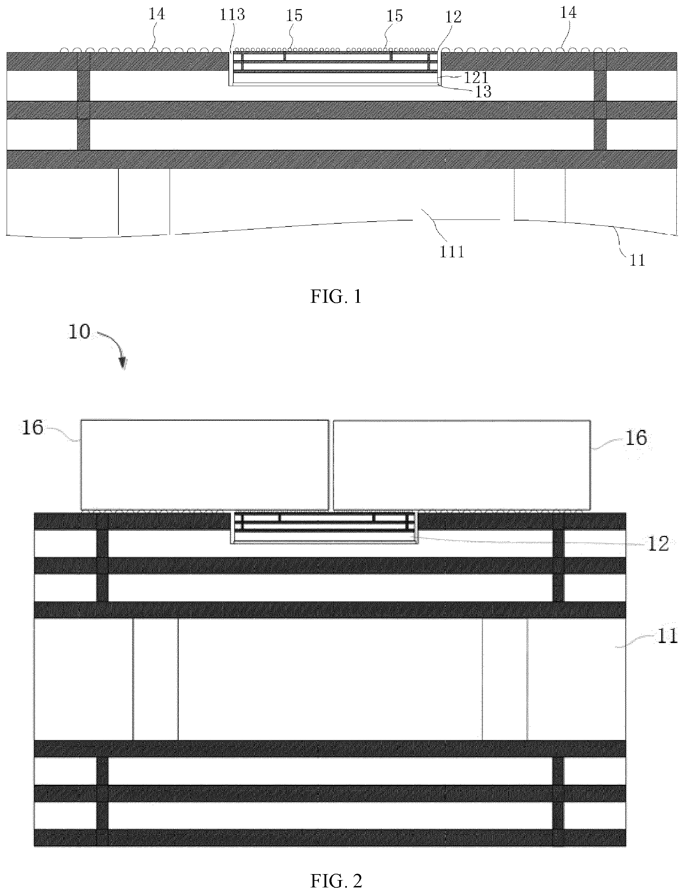

Figs. 1, 2, 4, 13, and 14 show the second metal routing connected with the plurality of second connection bumps (15) which does not form part of the present invention. The second metal routing not being connected with the plurality of second connection bumps (15) which forms part of the present invention is described in paragraph [0082].

### DETAILED DESCRIPTION

Hereinafter, the present disclosure will be described in details with reference to the accompanying drawings.

In an aspect, an embodiment of the present disclosure provides a package structure for connecting at least two dies, so as to realize high-bandwidth interconnection communication between the dies. As shown in FIGS. 1 to 4, the package structure of this embodiment includes a first package substrate 11 and at least one second package substrate 12.

The first package substrate 11 includes:
a first interconnection layer 112 including a first metal routing layer 1121 and a first dielectric layer 1122 which are alternately stacked; the first interconnection layer 112 is provided with at least one cavity 113.

The second package substrate 12 is arranged in the cavity 113 and includes:
a second interconnection layer 122 including a second metal routing layer 1221 and a second dielectric layer 1222 which are alternately stacked; the second dielectric layer 1222 includes an organic material, the organic material may specifically include polyimide, such as Poly(pyromellitic imide) (PMMI), Polyetherimide (PEI) and Polyamide-imide (PAI);
a layout density of metal routings in the second metal routing layer 1221 is greater than that of metal routings in the first metal routing layer 1121; that is, a line pitch and a line width of metal routings in the second metal routing layer 1221 are smaller than those in the first metal routing layer 1121, so that the first package substrate 11 can be used for low-density interconnection and the second package substrate 12 can be used for high-density interconnection.

The package structure of the embodiment of the present disclosure includes a first package substrate for low-density interconnection and a second package substrate for high-density interconnection. On the one hand, since an interposer of the second package substrate is made of an organic material, it's not necessary for the whole processing equipment and processing environment to adopt traditional silicon process, which lowers the production cost; on the other hand, under the circumstance that the package structure is applied in interconnection among dies, areas in which the dies require for high-density interconnection (such as signal transmission parts with high bandwidth requirements) can be interconnected through the second package substrate, and areas in which the dies do not require for high-density interconnection (such as signal transmission parts with relatively low power supply or bandwidth requirements) can be interconnected through the first package substrate or can be led out through the first package substrate; furthermore, the areas requiring for high-density interconnection can be realized by adopting precision technology, and the areas not requiring for high-density interconnection can be realized by adopting ordinary technology. Compared with the case of only using precision technology, the embodiment of the present disclosure can combine precision technology with ordinary technology to realize high-density interconnection, thus reducing the process cost.

Hereinafter, the first package substrate 11 and the second package substrate 12 in the package structure of the embodiment of the present disclosure will be described in details.

The first package substrate 11 can also be referred to as a first carrier, which can be a resin substrate, such as an ABF substrate.

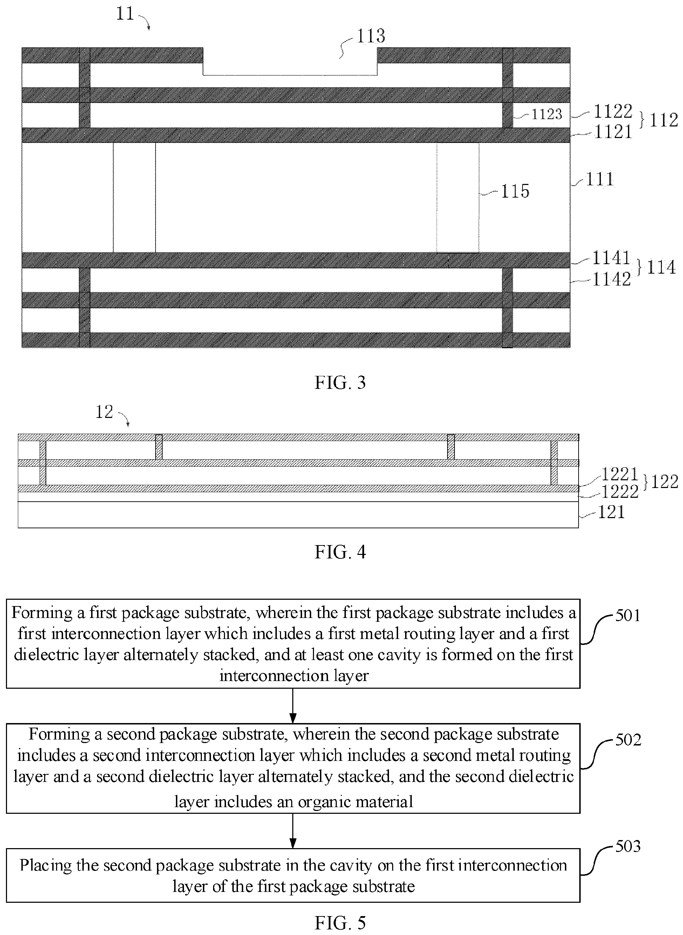

As shown in FIG. 3, in some examples, the first package substrate 11 may include a first base substrate 111 (used for supporting, also referred to as a core material or a support plate), and the first interconnection layer 112 is located on an upper surface of the first base substrate 111. The first interconnection layer 112 (i.e., a build-up layer, a laminated layer) includes a first metal routing layer 1121 and a first dielectric layer 1122 which are alternately stacked. In the embodiment shown in the figure, there are three first metal routing layers 1121 and two first dielectric layers 1122, and the number of the layers can be flexibly set as required, for example, up to 9 layers and 10 layers.

A core thickness of the first base substrate 111 may be 0.8 mm to 1.4 mm, and a core material of the first base substrate 111 may be silicon, glass, ceramics or the like. A line width and a line pitch of the metal routings (metal traces) in the first metal routing layer 1121 may both be 12 µm.

A material of the first dielectric layer 1122 can be a prepreg, which generally adopts ABF medium, and can be laminated on the first base substrate 111. A thickness of the first dielectric layer 1122 may be 20 µm to 30 µm.

The metal traces on different first dielectric layers 1122 may be connected through vias 1123. The via 1123 can be formed by laser drilling and copper plating, and a diameter of the via 1123 can be about 70 µm. The vias 1123 are filled by copper plating, so as to connect the metal traces of different layers.

The first interconnection layer 112 may be formed only on the upper surface of the first base substrate 111. In some other examples, in order to prevent the first base substrate 111 from bending and deforming, the first package substrate 11 may further include a third interconnection layer 114 and at least one connection structure, wherein the third interconnection layer 114 is located on a lower surface of the first base substrate 111 and includes a third metal routing layer 1141 and a third dielectric layer 1142 which are stacked alternately; the at least one connection structure passes through the first base substrate 111 to couple (electrically connect) the first interconnection layer 112 and the third interconnection layer 114.

The structure and formation mode of the third interconnection layer 114 are as same as those of the first interconnection layer 112, and the third and first interconnection layers are formed as symmetrical structures on the upper and lower surfaces of the first base substrate 111. The at least one connection structure can be specifically a via 115, and a diameter of the via 115 can be varied with the thickness of the first base substrate 111, usually between 0.15 mm and 0.25 mm. The via 115 can be formed by mechanical drilling, and an inner wall of the via is plated with copper, so as to connect the metal traces in upper and lower layers. After copper plating, the via can be filled with resin, which can not only exhaust the air so as to prevent the via from expanding and breaking due to a large coefficient of expansion of gas when heated, but can also planarize the surface of the base substrate.

Metal pins (not shown in the figure) can be connected to a lower surface/back surface of the first package substrate 11, so that the first package substrate 11 can be assembled on a motherboard (not shown in the figure) and connected with a circuit on the motherboard through the metal pins on the back surface of the first package substrate 11.

As shown in FIGS. 1 and 3, the first interconnection layer 112 of the first package substrate 11 is provided with at least one cavity 113 in which the second package substrate 12 can be embedded. In the first interconnection layer 112, the cavity 113 can be formed by a laser trenching process or by an etching process including exposure and development; and the second package substrate 12 can be fixed with the first package substrate 11 by using a double-sided die attach film 13 or a colloid.

The second package substrate 12 can also be referred to as a bridge substrate, a bridge block, an adapter substrate, an adapter block, and the like.

When the second package substrate 12 is embedded in the cavity 113 on the first bottom of the cavity 113; that is to say, the second package substrate 12 provides a support function through the bottom of the cavity 113. However, in order to facilitate the fabrication, transportation and installation of the second package substrate 12 on the first package substrate 11, as shown in FIGS. 1 and 4, in some examples, the second package substrate 12 may include a second base substrate 121 (used for supporting, also referred to as a support plate), and the second interconnection layer 122 is located on an upper surface of the second base substrate 121. A material of the second base substrate 121 may be an inorganic material, such as silicon, glass or ceramics. In the case that the second package substrate 12 has the second base substrate 121, the second package substrate 12 may be supported at a bottom of the cavity 113 through the second base substrate 121.

The second interconnection layer 122 (i.e., a build-up layer, a laminated layer) includes a second metal routing layer 1221 and a second dielectric layer 1222 which are alternately stacked. In the example shown in the figure, there are three second metal routing layers 1221 and three second dielectric layers 1222, and the number of the layers can be flexibly set as required, for example, up to five or six layers.

The second dielectric layer 1222 is made of an organic material, and the organic material may specifically include polyimide, such as Poly(pyromellitic imide) (PMMI), Polyetherimide (PEI) and Polyamide-imide (PAI), so that the whole environment of processing equipment does not need to adopt the traditional silicon process, and the production cost is reduced.

A line width and a line pitch of metal routings (metal traces) in the second metal routing layer 1221 may both be 0.5 µm to 5 µm, for example, 1 µm, 2 µm, 3 µm, etc.

A thickness (a dimension along a direction perpendicular to the second dielectric layer 1222, also referred to as a height) of the metal routing in the second metal routing layer 1221 may be as same as a width thereof. In some examples, a thickness-width ratio (a ratio of the thickness to the width) of the metal routing in the second metal routing layer 1221 may be 1:1-1:6, for example, 1:2, 1:3, 1:5, etc.

The package structure of the embodiment of the present disclosure can be sold separately; as shown in FIGS. 1 to 2, when used for interconnection among dies, the package structure can further include:
a plurality of first connection bumps 14 located on an upper surface of the first interconnection layer 112, that is, connected to the metal routings in the first metal routing layer 1121; and
a plurality of second connection bumps 15 located on an upper surface of the second interconnection layer 122, that is, connected to the metal routings in the second metal routing layer 1221.

In this case, the first connection bump 14 and the second connection bump 15 preferably satisfy at least one of the following:
a width of the second connection bump 15 is smaller than a width of the first connection bump 14; and
a distance between adjacent second connection bumps 15 is smaller than a distance between adjacent first connection bumps 14.

The first connection bump 14 is used to realize low-density interconnection between the first package substrate 11 and the die 16, so it may include only solder balls (not including copper pillars), or include both copper pillars and solder balls located at ends of the copper pillars. In some examples, a width (diameter) of the first connection bump 14 may be 50 µm to 80 µm, for example, 60 µm, 70 µm, or the like; a distance (pitch) between adjacent first connection bumps 14 may be 110 µm to 150 µm, for example, 120 µm, 130 µm, or the like.

The second connection bump 15 is used to realize high-density interconnection between the second package substrate 12 and the die 16, so it preferably includes copper pillars and solder balls located at ends of the copper pillars. In some examples, a width (diameter) of the second connection bump 15 may be 20 µm to 30 µm, for example, 20 µm, 25 µm, or the like; a distance (pitch) between adjacent second connection bumps 15 may be 40 µm to 60 µm, for example, 40 µm, 50 µm, or the like.

The first connection bump 14 and the second connection bump 15 preferably have the same height, in order to improve the assembling accuracy.

In the embodiment of the present disclosure, the width of the second connection bump 15 and the distance between adjacent second connection bumps 15 on the second package substrate 12 are smaller than the width of the first connection bumps 14 and the distance between adjacent first connection bumps 14 on the first package substrate 11. those arranged on the first package substrate 11, so high-density interconnection of signal lines between different dies can be realized, which is convenient for increasing a bandwidth of signal transmission.

Moreover, in the embodiment of the present disclosure, it is only necessary to form connection bumps on the upper surfaces of the first package substrate 11 and the second package substrate 12 for connection with different dies 16; the second package substrate 12 is fixed with the first package substrate 11 by using a double-sided die attach film 13 or a colloid; and there is no need to form connection bumps on the back surface of the second package substrate 12, which is beneficial to reducing the process cost.

In an example not forming part of the present invention but useful for understanding, both ends of each metal routing included in the second metal routing layer 1221 of the second interconnection layer 122 on the second package substrate 12 are is connected with the second connection bump 15, so as to realize signal transmission. In the embodiments of the present invention, second metal routing layer 1221 includes a first metal routing, a second metal routing and a third metal routing; both ends of the first metal routing and both ends of the third metal routing are connected with the plurality of second connection bumps 15 so as to realize signal transmission; both ends of the second metal routing are not connected with the plurality of second connection bumps 15 so as not to realize signal transmission; the first metal routing, the second metal routing and the third metal routing are arranged in parallel, and the second metal routing is located between the first metal routing and the third metal routing. In this way, between the first metal routing and the third metal routing connected with the second connection bump 15, there is a metal routing not connected with the second connection bump 15, which can reduce the mutual inductance effect between the first metal routing and the third metal routing connected with the second connection bump 15 and is beneficial to improving the quality of signal transmission.

In some examples, the second package substrate 12 may further include a reference plane dielectric layer (not shown in the figure) located on the upper surface of the second base substrate 121, and a metal layer is laid on the reference plane dielectric layer to form a signal reference layer, so as to form a signal reference plane for the second interconnection layer 122 and improve the signal transmission quality. The reference plane dielectric layer can be made of a material as same as that of the second dielectric layer 1222, such as polyimide, or a material different from that of the second dielectric layer 1222, such as silicon dioxide. The metal layer on the reference plane dielectric layer can be copper laid on the reference surface dielectric layer.

In another aspect, an embodiment of the present disclosure provides a chip 10. As shown in FIG. 2, the chip 10 includes at least two dies 16 and the package structure described above, and each die 16 is bonded (electrically connected) with the first package substrate 11 and the second package substrate 12 of the package structure, respectively. Since the package structure has been described particularly above, it will not be described in details here.

The chip of the embodiment of the present disclosure has a package structure including a first package substrate used for low-density interconnection and a second package substrate used for high-density interconnection. On the one hand, since an interposer of the second package substrate is made of an organic material, it's not necessary for the processing equipment and processing environment to adopt traditional silicon process, which lowers the production cost; on the other hand, areas in which the dies require for high-density interconnection (such as signal transmission parts with high bandwidth requirements) can be interconnected through the second package substrate, and areas in which the dies do not require for high-density interconnection (such as signal transmission parts with relatively low bandwidth requirements) can be interconnected through the first package substrate or can be led out through the first package substrate; furthermore, the areas requiring for high-density interconnection can be realized by adopting precision technology, and the areas not requiring for high-density interconnection can be realized by adopting ordinary technology. Compared with the case of only using precision technology, the embodiment of the present disclosure can combine precision technology with ordinary technology to realize high-density interconnection, thus reducing the process cost.

In yet another aspect, an embodiment of the present disclosure provides an electronic apparatus including a motherboard on which the above-described chip is arranged.

The implementation principles and technical effects of the electronic apparatus of the embodiment of the present disclosure are similar to those of the above-described chip, which will not be repeated here.

In still another aspect, an embodiment of the present disclosure provides a manufacturing method for a package structure, which is used for manufacturing the aforementioned package structure. As shown in FIGS. 1 to 5, the manufacturing method includes the following steps.

Step 501: forming a first package substrate 11. The first package substrate 11 includes a first interconnection layer 112, which includes a first metal routing layer 1121 and a first dielectric layer 1122 alternately stacked; and at least one cavity 113 is formed on the first interconnection layer 112.

As an alternative embodiment, forming the first package substrate (step 501) may include:
Step 5011: providing a first base substrate 111;
Step 5012: forming a first interconnection layer 112 on an upper surface of the first base substrate 111, forming a third interconnection layer 114 on a lower surface of the first base substrate 111, and forming at least one connection structure on the first base substrate 111. The third interconnection layer 114 includes a third metal routing layer 1141 and a third dielectric layer 1142 which are alternately stacked, and the at least one connection structure passes through the first base substrate 111 to couple the first interconnection layer 112 with the third interconnection layer 114.

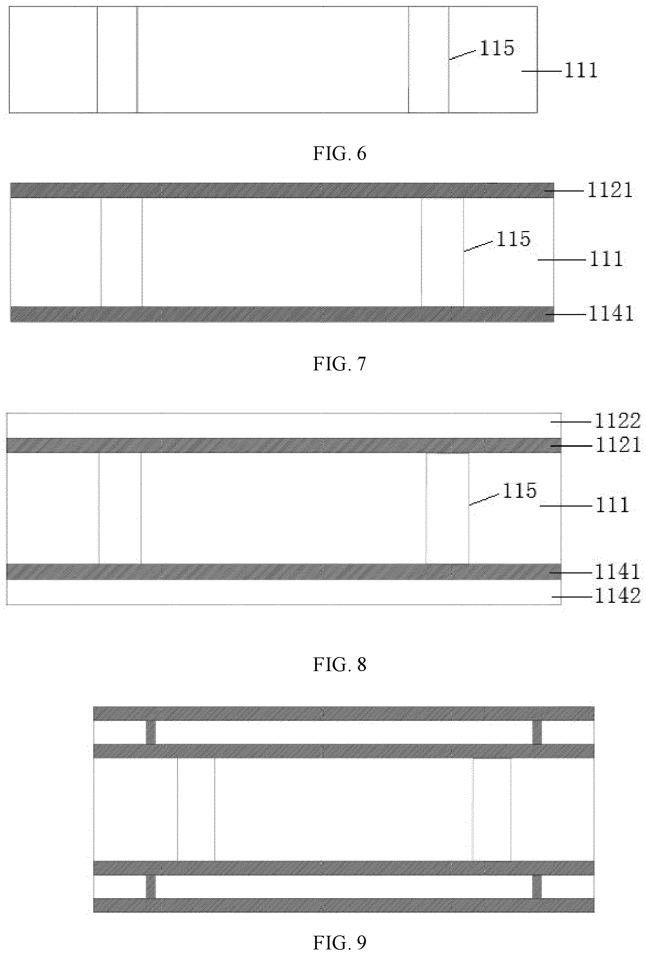

For specific process steps corresponding to this step, reference can be made to FIG. 6- FIG. 10.

FIG. 6 shows a first base substrate 111, on which a via 115 is formed. FIG. 7 shows that the upper and lower surfaces of the first base substrate 111 are formed with metal traces (i.e., a first metal routing layer 1121 and a second metal routing layer 1141) by copper plating and etching. The first base substrate 111 is an ABF substrate, which provides a support function and has a thickness of 0.4 mm to 1.6 mm. Mechanical drilling is performed on the first base substrate 111 to form the via 115, and a diameter of the via 115 may be between 0.1 mm and 0.25 mm. After the mechanical drilling is completed, copper plating is performed on an inner wall of the via to connect the metal traces on upper and lower layers of the first base substrate 111. After copper plating, the via is filled with resin, which exhausts the air on the one hand and planarizes the surface of the base substrate on the other hand.

Referring to FIG. 8, after the via 115 is completely filled, prepregs (i.e., a first dielectric layer 1122 and a third dielectric layer 1142) are laminated on the upper surface and the lower surface of the first base substrate 111 and used as ABF dielectric layers, and a thickness of the prepreg is generally 20 µm to 30 µm.

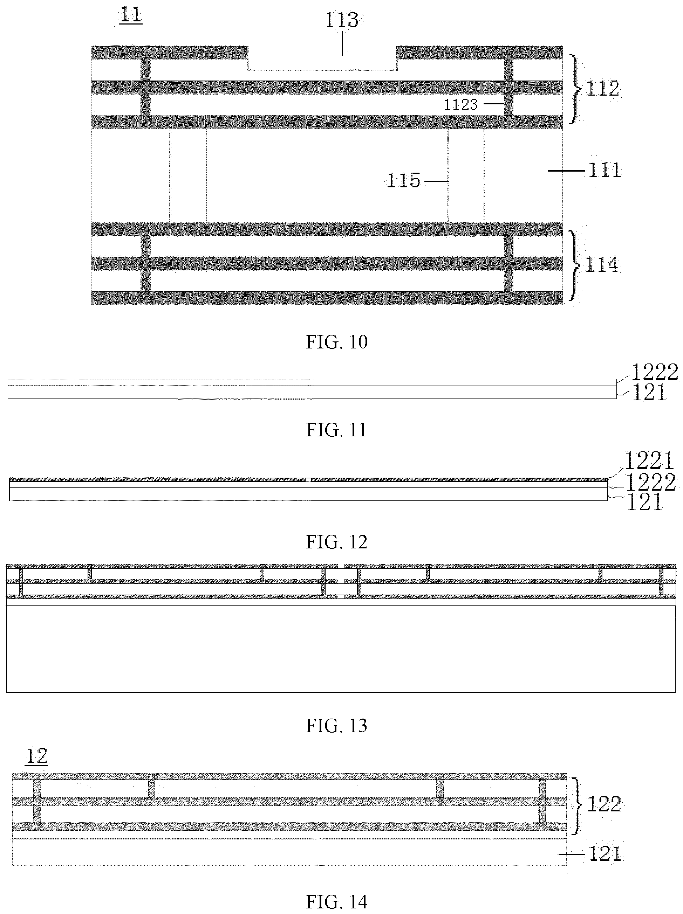

Then, referring to FIG. 9, the prepreg is formed with a via by laser drilling and is plated with copper to form another layer of metal traces (i.e., the first metal routing layer 1121 and the second metal routing layer 1141), and the copper as plated will completely fill the via (1123 in FIG. 10) to connect the metal traces on the upper and lower surfaces of the via. A diameter of the via formed by laser drilling is generally about 60-70 µm, and the copper plated on the prepreg can form metal traces with a line width and a line pitch of both 8-12 µm.

Then, by analogy, the prepregs are laminated, vias are formed by laser drilling, and copper is plated to complete the fabrication of the ABF laminated layer (build-up layer), as shown in FIG. 10.

Step 5013: forming at least one cavity 113 on the first interconnection layer 112.

In this step, referring to FIG. 10, the cavity 113 can be formed by laser trenching through burning, or by etching including exposure and development. The position error should be about 2 µm, the perpendicularity error of the cavity wall should be about 4 degrees, and the cavity size should be larger than that of the subsequent second package substrate 12 by about 60 µm. At this point, the fabrication of the first package substrate 11 and the cavity 113 is completed.

Step 502: forming a second package substrate 12. The second package substrate 12 includes a second interconnection layer 122, the second interconnection layer 122 includes a second metal routing layer 1221 and a second dielectric layer 1222 which are alternately stacked, and the second dielectric layer 1222 includes an organic material.

As an alternative embodiment, forming the second package substrate (step 502) may include:
Step 5021: providing a second base substrate 121;
Step 5022: forming the second interconnection layer 122 on an upper surface of the second base substrate 121.

For specific process steps corresponding to the above steps 5021 to 5022, reference can be made to FIG. 11 to FIG. 14.

FIG. 11 shows that the second base substrate 121 (support sheet) is covered with low-cost polyimide as the second dielectric layer 1222, and the second base substrate 121 is generally made of silicon or glass and has a thickness of about 700 µm; a thickness of the second dielectric layer 1222 is about 7 µm.

Then, referring to FIG. 12, high-density copper routings are electroplated on the second dielectric layer 1222 to form a second metal routing layer 1221, in which typical values of a line width and a line pitch of the metal routings are about 2 µm.

Then, referring to FIG. 13, low-cost polyimide is coated, again, as another second dielectric layer 1222, and vias with a diameter of about 10 µm are formed by etching, then high-density copper routings are electroplated to form another second metal routing layer 1221, and so on, until the fabrication of all the high-density routings is completed.

Finally, referring to FIG. 14, the second base substrate 121 can be thinned to about 50 µm by grinding, and then is sliced and separated to obtain a single second package substrate 12. At this point, the fabrication of the second package substrate 12 is completed.

Step 503: placing the second package substrate 12 in the cavity 113 on the first interconnection layer 112 of the first package substrate 11.

In this step, referring to FIG. 1, the second package substrate 12 can be embedded and fixed in the cavity 113 of the first package substrate 11 by using a double-sided die attach film 13 or a colloid.

A layout density of metal routings in the second metal routing layer 1221 is greater than that of metal routings in the first metal routing layer 1121.

In the above embodiment, the second package substrate 12 that has been fabricated in advance is embedded on the first package substrate 11. In some other examples, after the fabrication of the first package substrate 11 is completed, the second package substrate 12 can be directly formed in the cavity 113 of the first package substrate 11. The fabricating process of the second package substrate 12 is basically the same as the above method. In this case, it no longer needs the second package substrate 12 to be separately provided with the second base substrate 121, and the second package substrate 12 is individually formed as a single piece (instead of slicing from multiple substrates formed at the same time).

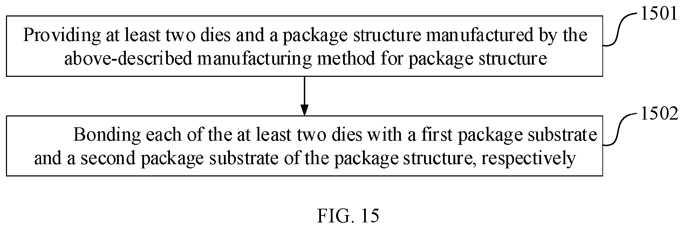

In still another aspect, an embodiment of the present disclosure provides a chip packaging method. As shown in FIG. 1 to FIG. 2 and FIG. 15, the chip packaging method includes the following steps.

Step 1501: providing at least two dies 16 and a package structure manufactured by the above-described manufacturing method for a package structure.

Step 1502: bonding each die 16 with the first package substrate 11 and the second package substrate 12 of the package structure respectively.

As an alternative embodiment, bonding each die with the first package substrate and the second package substrate of the package structure respectively (step 1502) includes the following steps.

Step 15021: form a plurality of first connection bumps 14 on an upper surface of the first interconnection layer 112 of the first package substrate 11, and forming a plurality of second connection bumps 15 on an upper surface of the second interconnection layer 122 of the second package substrate 12. The first connection bumps 14 and the second connection bumps 15 satisfy at least one of the following requirements: a width of the second connection bumps 15 is smaller than a width of the first connection bumps 14; and a distance between adjacent second connection bumps 15 is smaller than a distance between adjacent first connection bumps 14.

In this step, referring to FIG. 1, connection bumps (i.e., copper pillars and solder balls) are electroplated on the upper surfaces of the first package substrate 11 and the second package substrate 12 so as to form connection bumps with uniform height, uniform diameter and uniform pitch, respectively. The first connection bumps 14 on the first package substrate 11 may have a pitch of about 130 µm, and a diameter of about 70 µm. The second connection bumps 15 on the second package substrate 12 may have a pitch of about 50 µm, and a diameter of about 25 µm. The first connection bumps 14 and the second connection bumps 15 have the same heights.

Step 15022: forming a plurality of third connection bumps (not shown) in an area of each die 16 corresponding to the first package substrate 11, and forming a plurality of fourth connection bumps (not shown) in an area of each die 16 corresponding to the second package substrate 12.

In this step, connection bumps (i.e., copper pillars and solder balls) are electroplated on the die 16. The connection bumps also have two sizes, the third connection bumps corresponding to the first package substrate 11 have a pitch of about 130 µm and a diameter of about 70 µm; the fourth connection bumps corresponding to the second package substrate 12 have a pitch of about 50 µm and a diameter of about 25 µm; the third connection bumps and the fourth connection bumps have the same heights.

Step 15023: bonding each die 16 with the first package substrate 11 by using the third connection bump and the first connection bump 14, and bonding each die with the second package substrate 12 by using the fourth connection bump and the second connection bump 15.

In this step, the dies 16 can be flipped and soldered at the corresponding positions of the first package substrate 11 and the second package substrate 12. After soldering, the two dies 16 can be communicated through the second package substrate 12.

According to the chip packaging method of the embodiment of the present disclosure, the package structure includes a first package substrate used for low-density interconnection and a second package substrate used for high-density interconnection, so that high-density interconnection among dies can be completed at the lowest cost; on the one hand, the dielectric layer of the second package substrate adopts a low-cost dielectric material, namely polyimide, and it's not necessary for the processing equipment and processing environment to adopt the traditional silicon process, thereby reducing the production cost; on the other hand, the utilization of local high-density interconnection enables the precision technology to be combined with the ordinary technology so as to avoid a waste of the precision technology; and at the same time, it only needs to fabricate the connection bumps on the front surface of the second package substrate and it no longer needs to fabricate the connection bumps on the back surface, thereby improving the product yield.

In the above embodiments, the number of the cavity 113 on the first package substrate 11 is not limited to one, but may be more than one; and correspondingly, the number of the second package substrate 12 is not limited to one, but may also be more than one. The number of the second package substrate 12 is consistent with the number of the cavity 113. The second package substrate 12 is not limited to realizing interconnection between two dies, but can also realize high-density interconnection among a plurality of dies.

In all embodiments the second package substrate 12 can realize high-density interconnection among dies, which includes but is not limited to the following cases.

Interconnection between High Bandwidth Memory (HBM) and CPU;
Interconnection between CPUs;
Interconnection between computing chip and I/O chip;
Interconnection between CPU and Data Processing Unit (DPU);
Interconnection between CPU and Field Programmable Gate Array (FPGA);
Interconnection between CPU and optical communication module;
Interconnection among CPU, DPU and FPGA.

It should be noted that in the present disclosure, relational terms such as first and second are only used to distinguish one entity or operation from another entity or operation, and do not necessarily require or imply any such actual relationship or order between these entities or operations. Moreover, the terms "including", "comprising" or any other variations thereof are intended to cover non-exclusive inclusions, so that a process, method, article or equipment including a series of elements includes not only those elements, but also other elements not explicitly listed or elements inherent to such process, method, article or equipment. Without further restrictions, an element defined by the phrase "including one..." does not exclude the existence of other identical elements in the process, method, article or equipment including the element.

Various embodiments in the present disclosure are described in a related way, and only the same and similar parts between these various embodiments can be referred to each other, and each embodiment focuses on the difference(s) from other embodiments.

## Claims

1. A package structure, comprising a first package substrate (11) and at least one second package substrate (12), wherein the first package substrate (11) comprises:
a first interconnection layer (112), wherein the first interconnection layer (112) comprises a first metal routing layer (1121) and a first dielectric layer (1122) which are alternately stacked, and the first interconnection layer (112) is provided with at least one cavity (113);
the second package substrate (12) is arranged in the cavity (113), and the second package substrate (12) comprises:
a second interconnection layer (122), wherein the second interconnection layer (122) comprises a second metal routing layer (1221) and a second dielectric layer (1222) which are alternately stacked, and the second dielectric layer (1222) comprises an organic material;
wherein a layout density of metal routings in the second metal routing layer (1221) is greater than a layout density of metal routings in the first metal routing layer (1121), wherein the package structure further comprises:
a plurality of first connection bumps (14) located on an upper surface of the first interconnection layer (112); and
a plurality of second connection bumps (15) located on an upper surface of the second interconnection layer (122),
wherein the second metal routing layer (1221) comprises a first metal routing, a second metal routing and a third metal routing,
both ends of the first metal routing and both ends of the third metal routing are connected with the plurality of second connection bumps (15), and
both ends of the second metal routing are not connected with the plurality of second connection bumps (15).

2. The package structure according to claim 1, wherein the organic material comprises polyimide.

3. The package structure according to claim 1, wherein
a width of the second connection bump (15) is smaller than a width of the first connection bump (14); and/or,
a distance between adjacent second connection bumps (15) is smaller than a distance between adjacent first connection bumps (14).

4. The package structure according to claim 1, wherein the layout density of metal routings in the second metal routing layer (1221) is greater than the layout density of metal routings in the first metal routing layer (1121), comprising:
a line pitch and a line width of the metal routings in the second metal routing layer (1221) are smaller than those in the first metal routing layer (1121).

5. The package structure according to any one of claims 1-4, wherein the first package substrate (11) comprises a first base substrate (111), and the first interconnection layer (112) is located on an upper surface of the first base substrate (111), and
the first package substrate (11) further comprises:
a third interconnection layer (114), located on a lower surface of the first base substrate (111) and comprising a third metal routing layer (1141) and a third dielectric layer (1142) which are stacked alternately, and
at least one connection structure passing through the first base substrate (111) to couple the first interconnection layer (112) and the third interconnection layer (114),
preferably, the third interconnection layer (114) and the first interconnection layer (112) are formed as symmetrical structures.

6. The package structure according to any one of claims 1-4, wherein the second package substrate (12) comprises a second base substrate (121), and the second interconnection layer (122) is located on an upper surface of the second base substrate (121), so that the second package substrate (12) is supported at a bottom of the cavity (113) through the second base substrate (121).

7. A chip (10), comprising at least two dies (16) and the package structure according to any one of claims 1-6, wherein each of the at least two dies (16) is bonded with the first package substrate (11) and the second package substrate (12) of the package structure, respectively.

8. An electronic apparatus, comprising a motherboard, wherein
the motherboard is provided with the chip (10) according to claim 7.

9. A manufacturing method for a package structure, comprising:
forming a first package substrate (11), wherein the first package substrate (11) comprises a first interconnection layer (112), the first interconnection layer (112) comprises a first metal routing layer (1121) and a first dielectric layer (1122) which are alternately stacked, and the first interconnection layer (112) is provided with at least one cavity (113);
forming a second package substrate (12), wherein the second package substrate (12) comprises a second interconnection layer (122), the second interconnection layer (122) comprises a second metal routing layer (1221) and a second dielectric layer (1222) which are alternately stacked, and the second dielectric layer (1222) comprises an organic material; and
placing the second package substrate (12) in the cavity (113) on the first interconnection layer (112) of the first package substrate (11);
wherein a layout density of metal routings in the second metal routing layer (1221) is greater than a layout density of metal routings in the first metal routing layer (1121),
wherein,
the manufacturing method further comprises:
forming a plurality of first connection bumps (14) on an upper surface of the first interconnection layer (112); and
forming a plurality of second connection bumps (15) on an upper surface of the second interconnection layer (122),
wherein the second metal routing layer (1221) comprises a first metal routing, a second metal routing and a third metal routing,
both ends of the first metal routing and both ends of the third metal routing are connected with the plurality of second connection bumps (15), and
both ends of the second metal routing are not connected with the plurality of second connection bumps (15).

10. The manufacturing method according to claim 9, wherein the forming the first package substrate (11) comprises:
providing a first base substrate (111);
forming the first interconnection layer (112) on an upper surface of the first base substrate (111), forming a third interconnection layer (14) on a lower surface of the first base substrate (111), and forming at least one connection structure on the first base substrate (111), wherein the third interconnection layer (114) comprises a third metal routing layer (1141) and a third dielectric layer (1142) which are alternately stacked, and the at least one connection structure passes through the first base substrate (111) to couple the first interconnection layer (112) with the third interconnection layer (114); and
forming the at least one cavity (113) on the first interconnection layer (112).

11. The manufacturing method according to claim 9 or 10, wherein the forming the second package substrate comprises:
providing a second base substrate (121); and
forming the second interconnection layer (122) on an upper surface of the second base substrate (121).

12. A chip packaging method, comprising:
providing at least two dies (16) and the package structure manufactured by the manufacturing method according to any one of claims 9-11; and
bonding each of the at least two dies (16) with a first package substrate (11) and a second package substrate (12) of the package structure respectively.

13. The chip packaging method according to claim 12, wherein the bonding each of the at least two dies (16) with the first package substrate (11) and the second package substrate (12) of the package structure respectively comprises:
forming a plurality of first connection bumps (14) on an upper surface of a first interconnection layer (112) of the first package substrate (11), and forming a plurality of second connection bumps (15) on an upper surface of a second interconnection layer (122) of the second package substrate (12), wherein a width of the second connection bump (15) is smaller than a width of the first connection bump (14); and/or, a distance between adjacent second connection bumps (15) is smaller than a distance between adjacent first connection bumps (14);
forming a plurality of third connection bumps in an area of each of the at least two dies (16) corresponding to the first package substrate (11), and forming a plurality of fourth connection bumps in an area of each of the at least two dies (16) corresponding to the second package substrate (12); the plurality of third connection bumps and the plurality of fourth connection bumps being corresponding to the plurality of first connection bumps (14) and the plurality of second connection bumps (15), respectively, and
bonding each of the at least two dies (16) with the first package substrate (11) by using the third connection bump and the first connection bump (14), and bonding each of the at least two dies (16) with the second package substrate (12) by using the fourth connection bump and the second connection bump (15).

## Patentansprüche

1. Gehäusestruktur, umfassend ein erstes Gehäusesubstrat (11) und mindestens ein zweites Gehäusesubstrat (12), wobei
das erste Gehäusesubstrat (11) umfasst:
eine erste Verbindungsschicht (112), wobei die erste Verbindungsschicht (112) eine erste Metall-Routing-Schicht (1121) und eine erste dielektrische Schicht (1122) umfasst, die abwechselnd übereinandergeschichtet sind, und die erste Verbindungsschicht (112) mit mindestens einem Hohlraum (113) versehen ist;
das zweite Gehäusesubstrat (12) in dem Hohlraum (113) angeordnet ist und das zweite Gehäusesubstrat (12) umfasst:
eine zweite Verbindungsschicht (122), wobei die zweite Verbindungsschicht (122) eine zweite Metall-Routing-Schicht (1221) und eine zweite dielektrische Schicht (1222) umfasst, die abwechselnd übereinandergeschichtet sind, und die zweite dielektrische Schicht (1222) ein organisches Material umfasst;
wobei die Layoutdichte der Metallverdrahtungen in der zweiten Metall-Routing-Schicht (1221) größer ist als die Layoutdichte der Metallverdrahtungen in der ersten Metall-Routing-Schicht (1121),
wobei die Gehäusestruktur ferner umfasst:
eine Vielzahl von ersten Anschlusshöckern (14), die sich auf einer Oberseite der ersten Verbindungsschicht (112) befinden; und
eine Vielzahl von zweiten Anschlusshöckern (15), die auf einer Oberseite der zweiten Verbindungsschicht (122) angeordnet sind,
wobei die zweite Metall-Routing-Schicht (1221) eine erste Metallverdrahtung, eine zweite Metallverdrahtung und eine dritte Metallverdrahtung umfasst,
wobei beide Enden der ersten Metallverdrahtung und beide Enden der dritten Metallverdrahtung mit der Vielzahl zweiter Anschlusskontakte (15) verbunden sind, und
beide Enden der zweiten Metallverdrahtung nicht mit der Vielzahl von zweiten Anschlusshöckern (15) verbunden sind.

2. Die Gehäusestruktur nach Anspruch 1, wobei das organische Material Polyimid umfasst.

3. Die Gehäusestruktur nach Anspruch 1, wobei
die Breite des zweiten Anschlusshöckers (15) kleiner ist als die Breite des ersten Anschlusshöckers (14); und/oder
ein Abstand zwischen benachbarten zweiten Anschlusshöckern (15) kleiner ist als ein Abstand zwischen benachbarten ersten Anschlusshöckern (14).

4. Die Gehäusestruktur nach Anspruch 1, wobei die Layoutdichte der Metallverdrahtungen in der zweiten Metall-Routing-Schicht (1221) größer ist als die Layoutdichte der Metallverdrahtungen in der ersten Metall-Routing-Schicht (1121), umfassend:
ein Leitungsabstand und eine Leitungsbreite der Metallverdrahtungen in der zweiten Metall-Routing-Schicht (1221), die kleiner sind als diejenigen in der ersten Metall-Routing-Schicht (1121).

5. Die Gehäusestruktur nach einem der Ansprüche 1 bis 4, wobei das erste Gehäusesubstrat (11) ein erstes Basissubstrat (111) umfasst und die erste Verbindungsschicht (112) auf einer Oberseite des ersten Basissubstrats (111) angeordnet ist, und
das erste Gehäusesubstrat (11) ferner umfasst:
eine dritte Verbindungsschicht (114), die sich auf einer Unterseite des ersten Basissubstrats (111) befindet und eine dritte Metall-Routing-Schicht (1141) sowie eine dritte dielektrische Schicht (1142) umfasst, die abwechselnd übereinandergeschichtet sind, und
mindestens eine Verbindungsstruktur, die das erste Basissubstrat (111) durchquert, um die erste Verbindungsschicht (112) und die dritte Verbindungsschicht (114) miteinander zu koppeln,
wobei vorzugsweise die dritte Verbindungsschicht (114) und die erste Verbindungsschicht (112) als symmetrische Strukturen ausgebildet sind.

6. Die Gehäusestruktur nach einem der Ansprüche 1 bis 4, wobei das zweite Gehäusesubstrat (12) ein zweites Basissubstrat (121) umfasst und die zweite Verbindungsschicht (122) auf einer Oberseite des zweiten Basissubstrats (121) angeordnet ist, sodass das zweite Gehäusesubstrat (12) über das zweite Basissubstrat (121) am Boden des Hohlraums (113) abgestützt ist.

7. Chip (10), der mindestens zwei Halbleiterplättchen (16) und die Gehäusestruktur gemäß einem der Ansprüche 1 bis 6 umfasst, wobei jeder der mindestens zwei Halbleiterplättchen (16) jeweils mit dem ersten Gehäusesubstrat (11) und dem zweiten Gehäusesubstrat (12) der Gehäusestruktur verbunden ist.

8. Elektronisches Gerät, umfassend eine Hauptplatine, wobei
die Hauptplatine mit dem Chip (10) gemäß Anspruch 7 versehen ist.

9. Herstellungsverfahren für eine Gehäusestruktur, umfassend:
das Ausbilden eines ersten Gehäusesubstrats (11), wobei das erste Gehäusesubstrat (11) eine erste Verbindungsschicht (112) umfasst, die erste Verbindungsschicht (112) eine erste Metall-Routing-Schicht (1121) und eine erste dielektrische Schicht (1122) umfasst, die abwechselnd übereinandergeschichtet sind, und die erste Verbindungsschicht (112) mit mindestens einem Hohlraum (113) versehen ist;
Bilden eines zweiten Gehäusesubstrats (12), wobei das zweite Gehäusesubstrat (12) eine zweite Verbindungsschicht (122) umfasst, die zweite Verbindungsschicht (122) eine zweite Metall-Routing-Schicht (1221) und eine zweite dielektrische Schicht (1222) umfasst, die abwechselnd übereinandergeschichtet sind, und die zweite dielektrische Schicht (1222) ein organisches Material umfasst; und
Anordnen des zweiten Gehäusesubstrats (12) in dem Hohlraum (113) auf der ersten Verbindungsschicht (112) des ersten Gehäusesubstrats (11);
wobei die Layoutdichte der Metallverdrahtungen in der zweiten Metall-Routing-Schicht (1221) größer ist als die Layoutdichte der Metallverdrahtungen in der ersten Metall-Routing-Schicht (1121),
wobei
das Herstellungsverfahren ferner umfasst:
Bilden einer Vielzahl von ersten Anschlusshöckern (14) auf einer Oberseite der ersten Verbindungsschicht (112); und
Bilden einer Vielzahl von zweiten Anschlusshöckern (15) auf einer Oberseite der zweiten Verbindungsschicht (122),
wobei die zweite Metall-Routing-Schicht (1221) eine erste Metallverdrahtung, eine zweite Metallverdrahtung und eine dritte Metallverdrahtung umfasst,
beide Enden der ersten und beide Enden der dritten mit der Vielzahl von zweiten Anschlusshöckern (15) verbunden sind, und
beide Enden der zweiten Metallverdrahtung nicht mit der Vielzahl zweiter Anschlusshöcker (15) verbunden sind.

10. Das Herstellungsverfahren nach Anspruch 9, wobei das Ausbilden des ersten Gehäusesubstrats (11) umfasst:
Bereitstellen eines ersten Basissubstrats (111);
das Ausbilden der ersten Verbindungsschicht (112) auf einer Oberseite des ersten Basissubstrats (111), das Ausbilden einer dritten Verbindungsschicht (14) auf einer Unterseite des ersten Basissubstrats (111) und das Ausbilden mindestens einer Verbindungsstruktur auf dem ersten Basissubstrat (111), wobei die dritte Verbindungsschicht (114) eine dritte Metall-Routing-Schicht (1141) und eine dritte dielektrische Schicht (1142) umfasst, die abwechselnd übereinander geschichtet sind, und die mindestens eine Verbindungsstruktur das erste Basissubstrat (111) durchdringt, um die erste Verbindungsschicht (112) mit der dritten Verbindungsschicht (114) zu koppeln; und
Bilden des mindestens einen Hohlraums (113) auf der ersten Verbindungsschicht (112).

11. Das Herstellungsverfahren nach Anspruch 9 oder 10, wobei das Bilden des zweiten Gehäusesubstrats umfasst:
Bereitstellen eines zweiten Basissubstrats (121); und
Bilden der zweiten Verbindungsschicht (122) auf einer Oberseite des zweiten Basissubstrats (121).

12. Verfahren zur Chipverpackung, umfassend:
Bereitstellen von mindestens zwei Halbleiterplättchen (16) und der durch das Herstellungsverfahren gemäß einem der Ansprüche 9 bis 11 hergestellten Gehäusestruktur; und
das Verbinden jedes der mindestens zwei Halbleiterplättchen (16) jeweils mit einem ersten Gehäusesubstrat (11) und einem zweiten Gehäusesubstrat (12) der Gehäusestruktur.

13. Das Verfahren zur Chipverpackung nach Anspruch 12, wobei das Verbinden jedes der mindestens zwei Halbleiterplättchen (16) mit dem ersten Verpackungssubstrat (11) bzw. dem zweiten Verpackungssubstrat (12) der Verpackungsstruktur umfasst:
Bilden einer Vielzahl von ersten Anschlusshöckern (14) auf einer Oberseite einer ersten Verbindungsschicht (112) des ersten Gehäusesubstrats (11), und Bilden einer Vielzahl von zweiten Anschlusshöckern (15) auf einer Oberseite einer zweiten Verbindungsschicht (122) des zweiten Gehäusesubstrats (12), wobei eine Breite des zweiten Anschlusshöckers (15) kleiner ist als eine Breite des ersten Anschlusshöckers (14); und/oder ein Abstand zwischen benachbarten zweiten Anschlusshöckern (15) kleiner ist als ein Abstand zwischen benachbarten ersten Anschlusshöckern (14);
Bilden einer Vielzahl von dritten Anschlusshöckern in einem Bereich jedes der mindestens zwei Halbleiterplättchen (16), der dem ersten Gehäusesubstrat (11) entspricht, und Bilden einer Vielzahl von vierten Anschlusshöckern in einem Bereich jedes der mindestens zwei Halbleiterplättchen (16), der dem zweiten Gehäusesubstrat (12) entspricht; wobei die Vielzahl dritter Anschlusshöcker und die Vielzahl vierter Anschlusshöcker jeweils der Vielzahl erster Anschlusskontakte (14) und der Vielzahl zweiter Anschlusskontakte (15) entsprechen, und
Verbinden jedes der mindestens zwei Halbleiterplättchen (16) mit dem ersten Gehäusesubstrat (11) unter Verwendung des dritten Anschlusshöckers und des ersten Anschlusshöckers (14) sowie Verbinden jedes der mindestens zwei Halbleiterplättchen (16) mit dem zweiten Gehäusesubstrat (12) unter Verwendung des vierten Anschlusshöckers und des zweiten Anschlusshöckers (15).

## Revendications

1. Structure de boîtier, comprenant un premier substrat de boîtier (11) et au moins un second substrat de boîtier (12), dans laquelle
le premier substrat de boîtier (11) comprend :
une première couche d'interconnexion (112), dans laquelle la première couche d'interconnexion (112) comprend une première couche de routage métallique (1121) et une première couche diélectrique (1122) qui sont empilées alternativement, et la première couche d'interconnexion (112) est pourvue d'au moins une cavité (113) ;
le second substrat de boîtier (12) est agencé dans la cavité (113), et le second substrat de boîtier (12) comprend :
une deuxième couche d'interconnexion (122), dans laquelle la deuxième couche d'interconnexion (122) comprend une deuxième couche de routage métallique (1221) et une deuxième couche diélectrique (1222) qui sont empilées alternativement, et la deuxième couche diélectrique (1222) comprend un matériau organique ;
dans laquelle une densité de disposition de routages métalliques dans la deuxième couche de routage métallique (1221) est supérieure à une densité de disposition de routages métalliques dans la première couche de routage métallique (1121),
dans laquelle la structure de boîtier comprend en outre :
une pluralité de premières bosses de connexion (14) situées sur une surface supérieure de la première couche d'interconnexion (112) ; et
une pluralité de deuxièmes bosses de connexion (15) situées sur une surface supérieure de la deuxième couche d'interconnexion (122),
dans laquelle la deuxième couche de routage métallique (1221) comprend un premier routage métallique, un deuxième routage métallique et un troisième routage métallique,
les deux extrémités du premier routage métallique et les deux extrémités du troisième routage métallique sont connectées à la pluralité de deuxièmes bosses de connexion (15), et
les deux extrémités du deuxième routage métallique ne sont pas connectées à la pluralité de deuxièmes bosses de connexion (15).

2. Structure de boîtier selon la revendication 1, dans laquelle le matériau organique comprend du polyimide.

3. Structure de boîtier selon la revendication 1, dans laquelle
une largeur de la deuxième bosse de connexion (15) est inférieure à une largeur de la première bosse de connexion (14) ; et/ou
une distance entre des deuxièmes bosses de connexion (15) adjacentes est inférieure à une distance entre des premières bosses de connexion (14) adjacentes.

4. Structure de boîtier selon la revendication 1, dans laquelle la densité de disposition de routages métalliques dans la deuxième couche de routage métallique (1221) est supérieure à la densité de disposition de routages métalliques dans la première couche de routage métallique (1121), comprenant :
un pas de ligne et une largeur de ligne des routages métalliques dans la deuxième couche de routage métallique (1221) sont plus petits que ceux dans la première couche de routage métallique (1121).

5. Structure de boîtier selon l'une des revendications 1-4, dans laquelle le premier substrat de boîtier (11) comprend un premier substrat de base (111), et la première couche d'interconnexion (112) est située sur une surface supérieure du premier substrat de base (111), et
le premier substrat de boîtier (11) comprend en outre :
une troisième couche d'interconnexion (114), située sur une surface inférieure du premier substrat de base (111) et comprenant une troisième couche de routage métallique (1141) et une troisième couche diélectrique (1142) qui sont empilées alternativement, et
au moins une structure de connexion traversant le premier substrat de base (111) pour coupler la première couche d'interconnexion (112) et la troisième couche d'interconnexion (114),
de préférence, la troisième couche d'interconnexion (114) et la première couche d'interconnexion (112) sont formées comme des structures symétriques.

6. Structure de boîtier selon l'une des revendications 1-4, dans laquelle le second substrat de boîtier (12) comprend un second substrat de base (121), et la deuxième couche d'interconnexion (122) est située sur une surface supérieure du second substrat de base (121), de sorte que le second substrat de boîtier (12) est supporté au niveau d'un fond de la cavité (113) à travers le second substrat de base (121).

7. Puce (10), comprenant au moins deux dés (16) et la structure de boîtier selon l'une des revendications 1-6, dans laquelle chacun des au moins deux dés (16) est lié au premier substrat de boîtier (11) et au second substrat de boîtier (12) de la structure de boîtier, respectivement.

8. Appareil électronique, comprenant une carte mère, dans lequel
la carte mère est pourvue de la puce (10) selon la revendication 7.

9. Procédé de fabrication pour un substrat de boîtier, comprenant :
la formation d'un premier substrat de boîtier (11), dans lequel le premier substrat de boîtier (11) comprend une première couche d'interconnexion (112), la première couche d'interconnexion (112) comprend une première couche de routage métallique (1121) et une première couche diélectrique (1122) qui sont empilées alternativement, et la première couche d'interconnexion (112) est pourvue d'au moins une cavité (113) ;
la formation d'un second substrat de boîtier (12), dans lequel le second substrat de boîtier (12) comprend une deuxième couche d'interconnexion (122), la deuxième couche d'interconnexion (122) comprend une deuxième couche de routage métallique (1221) et une deuxième couche diélectrique (1222) qui sont empilées alternativement, et la deuxième couche diélectrique (1222) comprend un matériau organique ; et
le placement du second substrat de boîtier (12) dans la cavité (113) sur la première couche d'interconnexion (112) du premier substrat de boîtier (11) ;
dans lequel une densité de disposition de routages métalliques dans la deuxième couche de routage métallique (1221) est supérieure à une densité de disposition de routages métalliques dans la première couche de routage métallique (1121),
dans lequel le procédé de fabrication comprend en outre :
la formation d'une pluralité de premières bosses de connexion (14) sur une surface supérieure de la première couche d'interconnexion (112) ; et
la formation d'une pluralité de deuxièmes bosses de connexion (15) sur une surface supérieure de la deuxième couche d'interconnexion (122),
dans lequel la deuxième couche de routage métallique (1221) comprend un premier routage métallique, un deuxième routage métallique et un troisième routage métallique,
les deux extrémités du premier routage métallique et les deux extrémités du troisième routage métallique sont connectées à la pluralité de deuxièmes bosses de connexion (15), et
les deux extrémités du deuxième routage métallique ne sont pas connectées à la pluralité de deuxièmes bosses de connexion (15).

10. Procédé de fabrication selon la revendication 9, dans lequel la formation du premier substrat de boîtier (11) comprend :
la fourniture d'un premier substrat de base (111) ;
la formation de la première couche d'interconnexion (112) sur une surface supérieure du premier substrat de base (111), la formation d'une troisième couche d'interconnexion (14) sur une surface inférieure du premier substrat de base (111), et la formation d'au moins une structure de connexion sur le premier substrat de base (111), dans lequel la troisième couche d'interconnexion (114) comprend une troisième couche de routage métallique (1141) et une troisième couche diélectrique (1142) qui sont empilées alternativement, et l'au moins une structure de connexion traverse le premier substrat de base (111) pour coupler la première couche d'interconnexion (112) avec la troisième couche d'interconnexion (114) ; et
la formation de l'au moins une cavité (113) sur la première couche d'interconnexion (112).

11. Procédé de fabrication selon la revendication 9 ou 10, dans lequel la formation du second substrat de boîtier comprend :
la fourniture d'un second substrat de base (121) ; et
la formation de la deuxième couche d'interconnexion (122) sur une surface supérieure du second substrat de base (121).

12. Procédé d'encapsulation de puce, comprenant :
la fourniture d'au moins deux dés (16) et de la structure de boîtier fabriquée par le procédé de fabrication selon l'une des revendications 9-11 ; et
la liaison de chacun des au moins deux dés (16) à un premier substrat de boîtier (11) et un second substrat de boîtier (12) de la structure de boîtier respectivement.

13. Procédé d'encapsulation de puce selon la revendication 12, dans lequel la liaison de chacun des au moins deux dés (16) au premier substrat de boîtier (11) et au second substrat de boîtier (12) de la structure de boîtier comprend respectivement :
la formation d'une pluralité de premières bosses de connexion (14) sur une surface supérieure d'une première couche d'interconnexion (112) du premier substrat de boîtier (11), et la formation d'une pluralité de deuxièmes bosses de connexion (15) sur une surface supérieure d'une deuxième couche d'interconnexion (122) du second substrat de boîtier (12), dans lequel une largeur de la deuxième bosse de connexion (15) est inférieure à une largeur de la première bosse de connexion (14) ; et/ou, une distance entre des deuxièmes bosses de connexion (15) adjacentes est inférieure à une distance entre des premières bosses de connexion (14) adjacentes ;
la formation d'une pluralité de troisièmes bosses de connexion dans une zone de chacun des au moins deux dés (16) correspondant au premier substrat de boîtier (11), et la formation d'une pluralité de quatrièmes bosses de connexion dans une zone de chacun des au moins deux dés (16) correspondant au second substrat de boîtier (12) ; la pluralité de troisièmes bosses de connexion et la pluralité de quatrièmes bosses de connexion correspondant à la pluralité de premières bosses de connexion (14) et à la pluralité de deuxièmes bosses de connexion (15), respectivement, et
la liaison de chacun des au moins deux dés (16) au premier substrat de boîtier (11) en utilisant la troisième bosse de connexion et la première bosse de connexion (14), et la liaison de chacun des au moins deux dés (16) au second substrat de boîtier (12) en utilisant la quatrième bosse de connexion et la deuxième bosse de connexion (15).
